# EUROPEAN PATENT APPLICATION

(11) **EP 4 645 467 A1**
(43) Date of publication of application: **05.11.2025**
(21) Application number: 23943114.1
(22) Date of filing: 27.07.2023
(51) Int. Cl.: H01M 4/38, H01M 4/62, H01M 4/36, H01M 4/587, H01M 10/0525

(54) **METAL-DOPED SILICON-CARBON COMPOSITE MATERIAL AND PREPARATION METHOD THEREFOR AND USE THEREOF**

(30) Priority: 27.06.2023 CN 202310773017
(71) Applicant: Shinghwa Advanced Material Technology (Meishan) Co., Ltd., Meishan, Sichuan 620010 (CN); Shinghwa Advanced Material Technology (Lianjiang) Co., Ltd., Fuzhou, Fujian 350512 (CN); Shida Shingwa Advanced Material Group Co., Ltd., Dongying, Shandong 257503 (CN)
(72) Inventor: DING, Weitao, Shandong 257503 (CN); XING, Xianbo, Shandong 257503 (CN); LIU, Denghua, Shandong 257503 (CN); LIU, Dianzhong, Shandong 257503 (CN); GAO, Mingliang, Shandong 257503 (CN); WANG, Shuping, Shandong 257503 (CN)
(74) Representative: Meyer-Dulheuer MD Legal Patentanwälte PartG mbB
(86) International application number: PCT/CN2023/109693
(87) International publication number: WO 2025/000626

(57) **Abstract**

The present invention discloses a metal-doped silicon-carbon composite material, a preparation method thereof, and use thereof. The metal-doped silicon-carbon composite material includes a core-shell structure including a core and a shell. The core includes metal and/or heteroatom-doped porous carbon and nanosilicon. The shell includes lithium-doped amorphous carbon. A weight percentage of the shell in the core-shell structure is not greater than 10 wt%. According to the present invention, silicon storage performance of a porous carbon material is improved, so that specific capacity performance of the silicon-carbon composite material is further improved. The metal-doped silicon-carbon composite material, as a negative electrode material of a lithium-ion battery, has excellent power performance and initial efficiency. In addition, the preparation method provided in the present application is simple and effective, economical and practical, and easily scalable for industrialization.

## Description

The present application claims priority to Chinese Patent Application No. 202310773017X, filed with the China National Intellectual Property Administration on June 27, 2023 and entitled "METAL-DOPED SILICON-CARBON COMPOSITE MATERIAL, PREPARATION METHOD THEREOF, AND USE THEREOF", which is incorporated herein by reference in its entirety.

### TECHNICAL FIELD

The present invention pertains to the field of preparation of lithium-ion battery materials, and specifically, relates to a metal-doped silicon-carbon composite material. The present invention further relates to a preparation method and use of the metal-doped silicon-carbon composite material.

### BACKGROUND

A silicon-carbon composite material is applied in the field of high-energy-density lithium-ion batteries due to advantages thereof such as high energy density and extensive material sources. However, the silicon-carbon composite material has deficiencies such as large full-charge expansion and high impedance, resulting in a high-temperature storage deviation in the silicon-carbon composite material during use and resulting in risks such as subsequent capacity nosediving of a battery caused by large expansion. Currently, main measures for reducing expansion include: A nanocrystallized porous structure is used and a nanosilicon material with small silicon grains is used, to reduce material expansion during charging/discharging. Because the nanosilicon material with small silicon grains is used, a size is small (a size of the silicon grains < 2 nm) and is far less than a size (≈ 6 nm) of silicon grains of a silicon-oxygen material. Therefore, silicon expansion can be fundamentally reduced.

However, the applicants find that, currently, although nanosilicon prepared by using a silane pyrolysis method has small silicon grains and is deposited in porous carbon particles, poor electronic conductivity of the porous carbon particles leads to a poor rate capability of a material of the porous carbon particles. In addition, although a porous structure of porous carbon can reduce silicon expansion during charging/discharging, poor electronic conductivity of a material of the porous carbon leads to degradation in fast charging performance.

Therefore, the applicants hope to seek a technical solution to alleviate the above technical problems.

### SUMMARY

In view of this, the present invention aims to provide a metal-doped silicon-carbon composite material, a preparation method thereof, and use thereof. The metal-doped silicon-carbon composite material has excellent power performance and initial efficiency. In addition, the preparation method provided in the present application is simple and effective, economical and practical, and easily scalable for industrialization.

Technical solutions of the present invention are as follows:

A metal-doped silicon-carbon composite material is provided, including a core-shell structure including a core and a shell, where the core includes metal and/or heteroatom-doped porous carbon and nanosilicon, the shell includes lithium-doped amorphous carbon, and a weight percentage of the shell in the core-shell structure is not greater than 10 wt%.

Preferably, the weight percentage of the shell in the core-shell structure is 1 wt%-5 wt%.

Preferably, the metal in the core is silver and/or copper; and one or any combination of nitrogen, sulfur, or phosphorus is used as heteroatoms.

Preferably, in the core, a mass ratio range of the metal to the porous carbon to the nanosilicon is 1-5:40-60:40-60; and/or a mass ratio range of heteroatoms to the porous carbon to the nanosilicon is 1-5:40-60:40-60.

Preferably, a preparation method of the above metal-doped silicon-carbon composite material is provided, including at least the following operation steps:
(S1) uniformly mixing a carbon source with a heteroatomic compound and/or an organometallic compound, and then carbonizing a mixture under a temperature condition of 500°C-800°C for at least 1 hour, to obtain doped porous carbon;
(S2) transferring the doped porous carbon obtained in step (S1) to a first reaction kettle, and introducing a mixed gas of chlorosilane and an inert gas into the first reaction kettle under a temperature condition of 300°C-500°C for at least 1 hour, to obtain a silicon-carbon precursor material; and
(S3) transferring the silicon-carbon precursor material obtained in step (S2) to a second reaction kettle, vacuumizing the second reaction kettle to 10 kPa-100 kPa, and then introducing an atomized gas into the second reaction kettle to deposit and coat the atomized gas on a surface of the silicon-carbon precursor material, to obtain the metal-doped silicon-carbon composite material, where the atomized gas is obtained by vacuumizing and heating a chamber containing a shell coating solution, the shell coating solution includes at least a lithium salt, an activator, and an organic solvent, an introduction flow rate of the atomized gas is not less than 10 ml/min, and deposition duration is not less than 10 min.

Preferably, in step (S1), a mass ratio of the carbon source to the heteroatomic compound is 100:1-5; and/or a mass ratio of the carbon source to the organometallic compound is 100:1-5.

Preferably, in step (S1), the carbon source is one or any combination of phenolic resin, furfural resin, urea-formaldehyde resin, bisphenol F epoxy resin, bisphenol A epoxy resin, or bisphenol S epoxy resin; and/or the heteroatomic compound is one or any combination of urea, melamine, thiourea, thioacetamide, or phosphoric acid; and/or the organometallic compound is one or any combination of silver trifluoroacetate, silver stearate, silver benzoate, silver diethyldithiocarbamate, silver trifluoromethanesulfonate, copper 8-hydroxyquinoline, copper oleate, copper (II) carbonate dihydroxide, or copperphenylacetylide.

Preferably, in step (S2), a volume ratio of chlorosilane to the inert gas in the mixed gas is 1-5:10; and/or the first reaction kettle is vacuumized to 10 kPa-100 kPa before the mixed gas is introduced into the first reaction kettle, and a vacuum degree of the first reaction kettle is maintained at 100 kPa-1000 kPa after the mixed gas is introduced into the first reaction kettle; and/or an introduction flow rate of the mixed gas is 10 ml/min-50 ml/min, and introduction duration is 60 min-300 min.

Preferably, in the shell coating solution in step (S3), a mass ratio of the lithium salt to the activator to the organic solvent is 1-10:0.5-2:100; and/or the lithium salt is one or any combination of lithium borate, lithium tetraborate, lithium pyroborate, lithium metaborate, lithium tetrafluoroborate, or lithium stearate; the activator is one or any combination of CCl₃H, CCl₂H₂, or CClH₃; the organic solvent is one or any combination of dimethyl carbonate (DMC), diethyl carbonate (DEC), methyl ethyl carbonate (EMC), ethylene carbonate (EC), or propylene carbonate (PC); and the chamber containing the shell coating solution is vacuumized to 10 kPa-100 kPa and heated to 200°C-500°C to obtain the atomized gas.

Preferably, use of the above metal-doped silicon-carbon composite material is provided. The metal-doped silicon-carbon composite material is used as an active substance raw material for preparing an electrode sheet of a battery, preferably, as an active substance raw material of a negative electrode sheet of a lithium-ion battery.

In the present application, on the one hand, the porous carbon is doped with the heteroatoms and the metal, so that electronic conductivity of a porous carbon material is improved based on metallic silver and/or copper of the porous carbon material, and active sites on a surface of the porous carbon material are increased through heteroatom doping, thereby improving the electronic conductivity of the porous carbon material and enriching the active sites, effectively improving silicon storage performance of the porous carbon material, and finally improving specific capacity performance of the silicon-carbon composite material. In the present application, on the other hand, the shell coating solution that is in an atomized state and that contains the lithium salt and the activator is deposited on the silicon-carbon precursor material to perform deposition of the lithium-doped amorphous carbon, so as to prevent silicon grains from being enlarged due to silicon growth in a core structure. In addition, the lithium salt compound is coated on the surface of the silicon-carbon precursor material, so that when the silicon-carbon precursor material is used as an active substance raw material of an electrode sheet of a battery, lithium ions can be provided during charging/discharging of the battery to which the silicon-carbon precursor material is applied, thereby reducing an irreversible capacity of the battery, improving initial efficiency of the battery, and improving a rate capability. The metal-doped silicon-carbon composite material, as a negative electrode material of a lithium-ion battery, has excellent power performance and initial efficiency. In addition, the preparation method provided in the present application is simple and effective, economical and practical, and easily scalable for industrialization.

### DESCRIPTION OF THE DRAWINGS

FIG. 1 shows an SEM graph of a metal-doped silicon-carbon composite material prepared in Embodiment 1 of the present invention; and
FIG. 2 is a block diagram of preparation steps of a metal-doped silicon-carbon composite material according to a specific implementation of the present invention.

### DESCRIPTION OF EMBODIMENTS

An embodiment provides a metal-doped silicon-carbon composite material, including a core-shell structure including a core and a shell, where the core includes metal and/or heteroatom-doped porous carbon and nanosilicon, the shell includes lithium-doped amorphous carbon, and a weight percentage of the shell in the core-shell structure is not greater than 10 wt%. Preferably, in an implementation, the weight percentage of the shell in the core-shell structure is 1 wt%-5 wt%.

To improve electronic conductivity performance of the porous carbon, preferably, in an implementation, the metal in the core is silver and/or copper; and one or any combination of nitrogen, sulfur, or phosphorus is used as heteroatoms. Preferably, in an implementation, in the core, a mass ratio range of the metal to the porous carbon to the nanosilicon is 1-5:40-60:40-60; and/or a mass ratio range of heteroatoms to the porous carbon to the nanosilicon is 1-5:40-60:40-60.

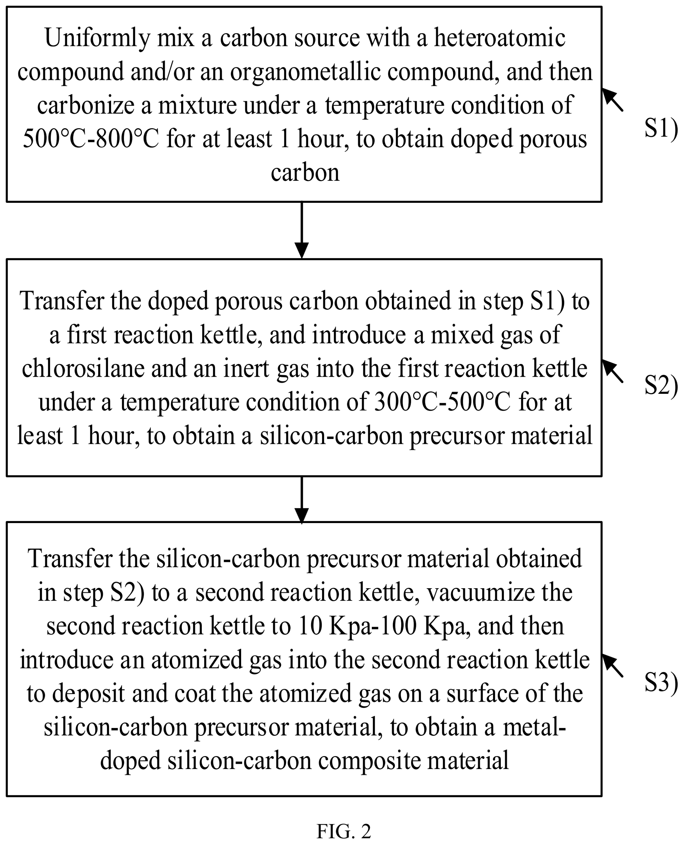

Preferably, an embodiment further provides a preparation method of the above metal-doped silicon-carbon composite material, as shown in FIG. 2, including at least the following operation steps:
(S1) A carbon source is uniformly mixed with a heteroatomic compound and/or an organometallic compound, and then a mixture is carbonized under a temperature condition of 500°C-800°C for at least 1 hour, to obtain doped porous carbon. Preferably, in step (S1), a mass ratio of the carbon source to the heteroatomic compound to the organometallic compound is 100:1-5:1-5. Preferably, in step (S1), the carbon source is one or any combination of phenolic resin, furfural resin, urea-formaldehyde resin, bisphenol F epoxy resin, bisphenol A epoxy resin, or bisphenol S epoxy resin; and/or the heteroatomic compound is one or any combination of urea, melamine, thiourea, thioacetamide, or phosphoric acid; and/or the organometallic compound is one or any combination of silver trifluoroacetate, silver stearate, silver benzoate, silver diethyldithiocarbamate, silver trifluoromethanesulfonate, copper 8-hydroxyquinoline, copper oleate, copper (II) carbonate dihydroxide, or copperphenylacetylide.
(S2) The doped porous carbon obtained in step (S1) is transferred to a first reaction kettle, and a mixed gas of chlorosilane and an inert gas is introduced into the first reaction kettle under a temperature condition of 300°C-500°C for at least 1 hour, to obtain a silicon-carbon precursor material. Preferably, in step (S2), a volume ratio of chlorosilane to the inert gas in the mixed gas is 1-5:10; and/or the first reaction kettle is vacuumized to 10 kPa-100 kPa before the mixed gas is introduced into the first reaction kettle, and a vacuum degree of the first reaction kettle is maintained at 100 kPa-1000 kPa after the mixed gas is introduced into the first reaction kettle; and/or an introduction flow rate of the mixed gas is 10 ml/min-50 ml/min, and introduction duration is 60 min-300 min.
(S3) The silicon-carbon precursor material obtained in step (S2) is transferred to a second reaction kettle, the second reaction kettle is vacuumized to 10 kPa-100 kPa, and then an atomized gas is introduced into the second reaction kettle to deposit and coat the atomized gas on a surface of the silicon-carbon precursor material, to obtain the metal-doped silicon-carbon composite material, where the atomized gas is obtained by vacuumizing and heating a chamber containing a shell coating solution, the shell coating solution includes at least a lithium salt, an activator, and an organic solvent, an introduction flow rate of the atomized gas is not less than 10 ml/min, more preferably 10 ml/min-100 ml/min, and deposition duration is not less than 10 min, more preferably 10 min-60 min. Preferably, in the shell coating solution in step (S3), a mass ratio of the lithium salt to the activator to the organic solvent is 1-10:0.5-2:100; and/or the lithium salt is one or any combination of lithium borate, lithium tetraborate, lithium pyroborate, lithium metaborate, lithium tetrafluoroborate, or lithium stearate; the activator is one or any combination of CCl₃H, CCl₂H₂, or CClH₃, which improves an effect of depositing the lithium salt compound on the surface of the silicon-carbon precursor material; the organic solvent is one or any combination of dimethyl carbonate (briefly referred to as "DMC"), diethyl carbonate (briefly referred to as "DEC"), methyl ethyl carbonate (briefly referred to as "EMC"), ethylene carbonate (briefly referred to as "EC"), or propylene carbonate (briefly referred to as "PC"); and the chamber containing the shell coating solution is vacuumized to 10 kPa-100 kPa and heated to 200°C-500°C to obtain the atomized gas.

Preferably, an embodiment further provides use of the above metal-doped silicon-carbon composite material. The metal-doped silicon-carbon composite material is used as an active substance raw material for preparing an electrode sheet of a battery, preferably, as an active substance raw material of a negative electrode sheet of a lithium-ion battery.

To enable a person skilled in the art to better understand the technical solutions in the present invention, the technical solutions in the embodiments of the present invention are clearly and completely described below with reference to the accompanying drawings in the embodiments of the present invention. Clearly, the described embodiments are merely some, rather than all, of the embodiments of the present invention. All other embodiments obtained by a person of ordinary skill in the art based on the embodiments of the present invention without creative efforts shall fall within the protection scope of the present invention.

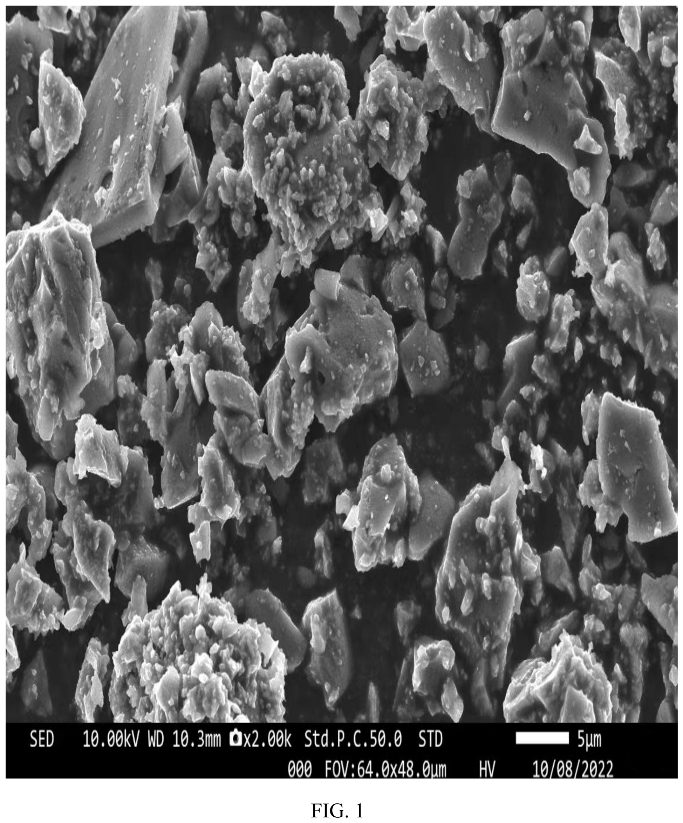

Based on the above described implementations, the present application further provides the following specific embodiments:
**Embodiment 1:** The following operation steps are used.
   Step (S1): 100 g of phenolic resin, 3 g of urea heteroatomic compound, and 3 g of silver trifluoroacetate are added to a ball mill and uniformly mixed, and a mixture is carbonized under a temperature condition of 600°C for 3 hours, to obtain doped porous carbon.
   Step (S2): The doped porous carbon obtained in step (S1) is transferred to a first reaction kettle, the first reaction kettle is vacuumized to 50 kPa, a chlorosilane-argon mixed gas (a volume ratio of chlorosilane to argon is 3:10) is introduced into the first reaction kettle, a vacuum degree of a chamber of the first reaction kettle is maintained at 500 kPa, the first reaction kettle is heated to 400°C, the mixed gas is introduced at an introduction flow rate of 30 ml/min for introduction duration of 120 min, and the doped porous carbon reacts with chlorosilane in the first reaction kettle to obtain a silicon-carbon precursor material.
   **Step (S3):** 5 g of lithium borate and 1 g of CCl₃H are added to 100 g of dimethyl carbonate organic solvent and uniformly dispersed in advance to obtain a shell coating solution; then the silicon-carbon precursor material obtained in step (S2) is transferred to a second reaction kettle, and the second reaction kettle is vacuumized to 50 kPa; and the shell coating solution is transferred to a vaporization chamber, the vaporization chamber is vacuumized to 50 kPa and heated to 300°C to generate an atomized gas, and the atomized gas is introduced into the second reaction kettle at an introduction flow rate of 50 ml/min and is deposited for 30 min to deposit and coat the atomized gas on a surface of the silicon-carbon precursor material, to obtain a metal-doped silicon-carbon composite material in Embodiment 1.
   In the present application, an SEM test is performed on the metal-doped silicon-carbon composite material prepared in Embodiment 1. For a test result, refer to FIG. 1. It can be learned from FIG. 1 that the material is of a granular structure, and material particles have a uniform and rational size distribution, and surfaces of the material particles exhibit slight adhesion of fine particles. Sizes of the particles are in a range of 3 µm-7 µm.
**Embodiment 2:** The following operation steps are used.
   **Step (S1):** 100 g of furfural resin, 1 g of melamine, and 1 g of silver stearate are added to a ball mill and uniformly mixed, and a mixture is carbonized under a temperature condition of 500°C for 6 hours, to obtain doped porous carbon.
   **Step (S2):** The doped porous carbon obtained in step (S1) is transferred to a first reaction kettle, the first reaction kettle is vacuumized to 10 kPa, a chlorosilane-argon mixed gas (a volume ratio of chlorosilane to argon is 1:10) is introduced into the first reaction kettle, a vacuum degree of a chamber of the first reaction kettle is maintained at 100 kPa, the first reaction kettle is heated to 300°C, the mixed gas is introduced at an introduction flow rate of 10 ml/min for introduction duration of 300 min, and the doped porous carbon reacts with chlorosilane in the first reaction kettle to obtain a silicon-carbon precursor material.
   **Step (S3):** 1 g of lithium pyroborate and 0.5 g of CCl₂H₂ are added to 100 g of diethyl carbonate organic solvent and uniformly dispersed in advance to obtain a shell coating solution; then the silicon-carbon precursor material obtained in step (S2) is transferred to a second reaction kettle, and the second reaction kettle is vacuumized to 10 kPa; and the shell coating solution is transferred to a vaporization chamber, the vaporization chamber is vacuumized to 10 kPa and heated to 200°C to generate an atomized gas, and the atomized gas is introduced into the second reaction kettle at an introduction flow rate of 100 ml/min and is deposited for 10 min to deposit and coat the atomized gas on a surface of the silicon-carbon precursor material, to obtain a metal-doped silicon-carbon composite material in Embodiment 2.
**Embodiment 3:** The following operation steps are used.
   **Step (S1):** 100 g of urea-formaldehyde resin, 5 g of phosphoric acid, and 5 g of silver benzoate organometallic compound are added to a ball mill and uniformly mixed, and a mixture is carbonized under a temperature condition of 800°C for 1 hour, to obtain doped porous carbon.
   **Step (S2):** The doped porous carbon obtained in step (S1) is transferred to a first reaction kettle, the first reaction kettle is vacuumized to 100 kPa, a chlorosilane-argon mixed gas (a volume ratio of chlorosilane to argon is 5:10) is introduced into the first reaction kettle, a vacuum degree of a chamber of the first reaction kettle is maintained at 1000 kPa, the first reaction kettle is heated to 500°C, the mixed gas is introduced at an introduction flow rate of 50 ml/min for introduction duration of 60 min, and the doped porous carbon reacts with chlorosilane in the first reaction kettle to obtain a silicon-carbon precursor material.
   **Step (S3):** 10 g of lithium tetrafluoroborate and 2 g of CClH₃ are added to 100 g of methyl ethyl carbonate organic solvent and uniformly dispersed in advance to obtain a shell coating solution; then the silicon-carbon precursor material obtained in step (S2) is transferred to a second reaction kettle, and the second reaction kettle is vacuumized to 100 kPa; and the shell coating solution is transferred to a vaporization chamber, the vaporization chamber is vacuumized to 100 kPa and heated to 500°C to generate an atomized gas, and the atomized gas is introduced into the second reaction kettle at an introduction flow rate of 100 ml/min and is deposited for 10 min to deposit and coat the atomized gas on a surface of the silicon-carbon precursor material, to obtain a metal-doped silicon-carbon composite material in Embodiment 3.
**Embodiment 4:** The remaining technical solutions of Embodiment 4 are the same as those of Embodiment 1. A difference lies only in that 3 g of urea heteroatomic compound is removed from step (S1) of Embodiment 4.
**Embodiment 5:** The remaining technical solutions of Embodiment 5 are the same as those of Embodiment 1. A difference lies only in that 3 g of silver trifluoroacetate is removed from step (S1) of Embodiment 5.

**Comparative Example 1:** The remaining technical solutions of Comparative Example 1 are the same as those of Embodiment 1. A difference lies only in that step (S1) is cancelled in Comparative Example 1, the doped porous carbon obtained in step (S1) is replaced with porous carbon to implement step (S2) and step (S3). A preparation method of the porous carbon in Comparative Example 1 is that 100 g of phenolic resin is carbonized under a temperature condition of 600°C for 3 hours to obtain the porous carbon.

**Comparative Example 2:** The remaining technical solutions of Comparative Example 2 are the same as those of Embodiment 1. A difference lies only in that, in Comparative Example 2, the vacuum degree of the first reaction kettle in step (S2) is set to atmospheric pressure, and the vacuum degree of the second reaction kettle in step (S3) is set to atmospheric pressure.

**Comparative Example 3:** The remaining technical solutions of Comparative Example 3 are the same as those of Embodiment 1. A difference lies only in that step (S3) is cancelled in Comparative Example 3, and the silicon-carbon precursor material obtained in step (S2) is directly used as a silicon-carbon composite material.

**Comparative Example 4:** The remaining technical solutions of Comparative Example 4 are the same as those of Embodiment 1. A difference lies only in that step (S2) and step (S3) are cancelled in Comparative Example 4, and the doped porous carbon obtained in step (S1) is directly used as a composite material.

**Comparative Example 5:** The remaining technical solutions of Comparative Example 5 are the same as those of Embodiment 1. A difference lies only in that step (S2) is cancelled in Comparative Example 5, and the silicon-carbon precursor material obtained in step (S2) is directly replaced with the doped porous carbon obtained in step (S1) to implement step (S3).

To compare and verify effects of the above embodiments and comparative examples, in the present application, physical and chemical tests are performed on the composite materials obtained in Embodiments 1-5 and Comparative Examples 1-5.
(1) A specific surface area and tap density of each composite material are tested according to the national standard GB/T 38823-2020 "Silicon-Carbon", conductivity of each composite material is tested by using a four-probe tester, and pore size, pore volume, and powder conductivity parameters of the doped porous carbon in Embodiments 1-5 and Comparative Examples 2-5 and the porous carbon in Comparative Example 1 are further separately tested. For test results thereof, refer to Table 1.
(2) Button battery test

The composite materials corresponding to Embodiments 1-5 and Comparative Examples 1-5 each are used as a negative electrode material of a lithium-ion battery to prepare a button battery according to the following method:
adding a binder, a conductive agent, and a solvent to each corresponding composite material, performing stirring to prepare a slurry, coating the slurry on a copper foil, and drying and pressing the copper foil to obtain a negative electrode sheet, where the binder is LA132, the conductive agent is SP (conductive carbon black), the solvent is NMP, a dosage ratio of the composite material to SP to LA132 to NMP is 95 g:1 g:4 g:220 mL, an electrolyte solution is a solution with LiPF₆ as an electrolyte and with a concentration of 1 mol/L, the solvent is a mixture of EC and DEC with a volume ratio of 1:1, a lithium metal sheet is a counter electrode, and a membrane is a polypropylene (PP) membrane.

Each button battery is assembled in a glovebox filled with argon, and then an electrochemical performance test is performed. Specifically, the electrochemical performance test is performed by using a CT2001A battery tester of WUHAN LAND, a charging/discharging voltage range is 0.005 V to 2.0 V, and a charging/discharging rate is 0.1 C. For test results, refer to Table 1.

Full-charge expansion is further performed on the negative electrode sheet of the above button battery. A specific test process is as follows: An electrode sheet test is performed on a rolled button battery to obtain a thickness D1 of the negative electrode sheet, a full-charge thickness D2 of the negative electrode sheet is measured through dissection when the button battery is fully charged to a 100% SOC, and an expansion rate is calculated (expansion rate = (D2-D1)/D1*100%). For test results, refer to Table 1.

**Table 1**

| | Initial specific discharge capacity (mAh/g) | Initial efficiency (%) | Specific surface area (m²/g) | Tap density (g/cm³) | Powder conductivity (S/cm) | Full-charge expansion | Pore size (nm) | Pore volume (cm³/g) |
|---|---|---|---|---|---|---|---|---|
| Embodiment 1 | 1851.6 | 93.9 | 5.1 | 0.96 | 6.57 | 45.0% | 2.23 | 1.82 |
| Embodiment 2 | 1832.5 | 94.1 | 5.9 | 0.94 | 5.54 | 42.2% | 2.71 | 1.23 |
| Embodiment 3 | 1864.4 | 93.1 | 4.6 | 1.02 | 7.40 | 46.5% | 2.12 | 2.03 |
| Embodiment 4 | 1821.6 | 92.8 | 4.5 | 0.91 | 4.57 | 49.0% | 2.10 | 1.43 |
| Embodiment 5 | 1802.1 | 92.4 | 4.7 | 0.90 | 3.51 | 48.8% | 2.11 | 1.54 |
| Comparative Example 1 | 1664.8 | 90.6 | 4.1 | 0.86 | 1.12 | 68.5% | 3.45 | 0.78 |
| Comparative Example 2 | 1710.4 | 91.3 | 3.7 | 0.81 | 2.31 | 72.6% | 2.23 | 1.82 |
| Comparative Example 3 | 1658.9 | 87.6 | 2.1 | 0.89 | 2.56 | 56.9% | 2.23 | 1.82 |
| Comparative Example 4 | 347 | 67.9 | 4.5 | 0.95 | 12.67 | 98.5% | 5.67 | 0.12 |
| Comparative Example 5 | 356 | 85.7 | 2.5 | 0.91 | 1.07 | 25.6% | 0.21 | 0.03 |

It can be learned from data in Table 1 that specific capacities and initial efficiencies of the silicon-carbon composite materials prepared in Embodiments 1-5 of the present application are significantly better than those of the composite materials prepared in Comparative Examples 1-5. Reasons may be as follows: The core of the silicon-carbon composite material provided in the embodiments of the present application is made of the doped porous carbon, which significantly improves electronic conductivity of the material, significantly reduces impedance, and suppresses material expansion during charging/discharging. In addition, the lithium salt coated on the outer layer can further reduce an irreversible capacity of the battery to which the material is applied, thereby improving initial efficiency of the battery.

### (3) Pouch battery performance test

The composite materials corresponding to Embodiments 1-5 and Comparative Examples 1-5 each are doped with 90% artificial graphite, an obtained product is used as a negative electrode material (that is, a negative electrode sheet), and the negative electrode material, a positive electrode ternary material (LiNi_{1/3}Co_{1/3}Mn_{1/3}O₂), an electrolyte solution, and a membrane are assembled into a 5 Ah pouch battery, where the membrane is celegard 2400, and the electrolyte solution is a LiPF₆ solution (a solvent is a mixed solution of EC and DEC with a volume ratio of 1:1, and a concentration of LiPF₆ is 1.3 mol/L).

The following performance tests are performed on each pouch battery.
a. Electrolyte solution adsorption capability test: drawing up V mL of electrolyte solution by using a 1 mL burette, adding a drop of electrolyte solution on a surface of each negative electrode sheet, performing timing until the electrolyte solution is completely absorbed, recording a time t, and calculating an electrolyte solution adsorption speed S=V/t of each negative electrode sheet. For test results, refer to Table 2.
b. Electrolyte solution retention rate test: calculating a theoretical electrolyte solution absorption amount m1 of a corresponding negative electrode sheet based on a parameter of each negative electrode sheet, weighing a weight m2 of the negative electrode sheet, then placing the negative electrode sheet in the electrolyte solution to soak for 24 hours, weighing a weight m3 of the negative electrode sheet, calculating an electrolyte solution absorption amount m3-m2 of the negative electrode sheet, and performing calculation according to the following formula:
   electrolyte solution retention rate = (m3-m2)*100%/m1. For test results, refer to Table 2.

**Table 2**

| | Electrolyte solution absorption speed (S) | Electrolyte solution retention rate |
|---|---|---|
| Embodiment 1 | 38 | 92.3% |
| Embodiment 2 | 31 | 93.1% |
| Embodiment 3 | 46 | 91.5% |
| Embodiment 4 | 60 | 89.7% |
| Embodiment 5 | 53 | 90.3% |
| Comparative Example 1 | 78 | 88.7% |
| Comparative Example 2 | 82 | 87.3% |
| Comparative Example 3 | 86 | 86.5% |
| Comparative Example 4 | 59 | 89.6% |
| Comparative Example 5 | 84 | 86.9% |

It can be learned from Table 2 that electrolyte solution absorption and retention capabilities of the silicon-carbon composite materials provided in Embodiments 1-5 are better than those of the composite materials in Comparative Examples 1-5. A reason may be that the specific surface area of the silicon-carbon composite material provided in the embodiments of the present application is larger, which can directly improve the electrolyte solution absorption and retention capabilities of the silicon-carbon composite material. In addition, the electrolyte solution absorption and retention capabilities in Embodiments 1-3 are significantly better than those in Embodiments 4-5. It can be learned that doping the porous carbon with both metal and heteroatoms achieves an obviously better effect.

c. Rate and cycle performance tests: A cycle performance test and a rate test are performed on each prepared pouch battery. Test conditions of the cycle performance test are as follows: A charging/discharging voltage range is 2.5 V-4.2 V, a temperature is 25°C±3.0°C, a charging/discharging rate is 0.5 C/1.0 C, and a quantity of cycles is 500. A test condition of the rate test is as follows: A constant-current ratio of each pouch battery is tested under a 2C condition. For test results, refer to Table 3.

**Table 3**

| | Initial capacity retention rate (%) | Capacity retention rate (%) after 500 cycles | 2C constant-current ratio |
|---|---|---|---|
| Embodiment 1 | 100 | 94.4 | 89.3% |
| Embodiment 2 | 100 | 93.6 | 87.8% |
| Embodiment 3 | 100 | 94.9 | 90.5% |
| Embodiment 4 | 100 | 91.2 | 88.5% |
| Embodiment 5 | 100 | 91.8 | 87.4% |
| Comparative Example 1 | 100 | 88.5 | 82.2% |
| Comparative Example 2 | 100 | 87.6 | 84.3% |
| Comparative Example 3 | 100 | 86.5 | 85.6% |
| Comparative Example 4 | 100 | 56.7 | 92.7% |
| Comparative Example 5 | / | / | / |

It can be learned from Table 3 that rates and cycle performance of lithium-ion pouch batteries prepared by using the silicon-carbon composite materials provided in Embodiments 1-5 are significantly better than those of batteries prepared by using the composite materials in Comparative Examples 1-4 (because the initial specific discharge capacity of Comparative Example 5 is excessively low, a rate and cycle performance of the pouch battery prepared by using the composite material in Comparative Example 5 are not tested). Reasons may be as follows: The surface of the silicon-carbon composite material provided in the embodiments of the present application is coated with the lithium salt, which can directly increase a lithium ion insertion/extraction rate of the battery, thereby improving constant-current ratio performance of the battery. In addition, because the doped porous carbon used by the core has excellent electronic conductivity, constant-current ratio performance of the battery to which the material is applied can be further improved. Moreover, cycle performance of Embodiments 1-3 is significantly better than that of Embodiments 4-5. It can be learned that doping the porous carbon with both metal and heteroatoms achieves an obviously better effect.

It will be clear to a person skilled in the art that the present invention is not limited to the details of the above example embodiments, and the present invention can be implemented in other specific forms without departing from the essential features of the present invention. Therefore, the embodiments should be regarded in all respects as examples rather than as restrictive, and the scope of the present invention is defined by the appended claims rather than the above descriptions. Therefore, all changes falling within the meanings and scope of equivalent elements of the claims are included in the present invention. Any reference numeral in the claims shall not be construed as limiting the claims.

In addition, it should be understood that, although this specification has been described with reference to implementations, not every implementation includes only one independent technical solution, and such description of this specification is by way of clarity only. A person skilled in the art should take this specification as a whole, and the technical solutions of the embodiments may be combined as appropriate to obtain other implementations that can be understood by a person skilled in the art.

## Claims

1. A metal-doped silicon-carbon composite material, comprising a core-shell structure comprising a core and a shell, wherein the core comprises metal and/or heteroatom-doped porous carbon and nanosilicon, the shell comprises lithium-doped amorphous carbon, and a weight percentage of the shell in the core-shell structure is not greater than 10 wt%.

2. The metal-doped silicon-carbon composite material according to claim 1, wherein the weight percentage of the shell in the core-shell structure is 1 wt%-5 wt%.

3. The metal-doped silicon-carbon composite material according to claim 1, wherein the metal in the core is silver and/or copper; and one or any combination of nitrogen, sulfur, or phosphorus is used as heteroatoms.

4. The metal-doped silicon-carbon composite material according to claim 1, wherein in the core, a mass ratio range of the metal to the porous carbon to the nanosilicon is 1-5:40-60:40-60; and/or a mass ratio range of heteroatoms to the porous carbon to the nanosilicon is 1-5:40-60:40-60.

5. A preparation method of the metal-doped silicon-carbon composite material according to any one of claims 1-4, comprising at least the following operation steps:
(S1) uniformly mixing a carbon source with a heteroatomic compound and/or an organometallic compound, and then carbonizing a mixture under a temperature condition of 500°C-800°C for at least 1 hour, to obtain doped porous carbon;
(S2) transferring the doped porous carbon obtained in step (S1) to a first reaction kettle, and introducing a mixed gas of chlorosilane and an inert gas into the first reaction kettle under a temperature condition of 300°C-500°C for at least 1 hour, to obtain a silicon-carbon precursor material; and
(S3) transferring the silicon-carbon precursor material obtained in step (S2) to a second reaction kettle, vacuumizing the second reaction kettle to 10 kPa-100 kPa, and then introducing an atomized gas into the second reaction kettle to deposit and coat the atomized gas on a surface of the silicon-carbon precursor material, to obtain the metal-doped silicon-carbon composite material, wherein the atomized gas is obtained by vacuumizing and heating a chamber containing a shell coating solution, the shell coating solution comprises at least a lithium salt, an activator, and an organic solvent, an introduction flow rate of the atomized gas is not less than 10 ml/min, and deposition duration is not less than 10 min.

6. The preparation method of the metal-doped silicon-carbon composite material according to claim 5, wherein in step (S1), a mass ratio of the carbon source to the heteroatomic compound is 100:1-5; and/or a mass ratio of the carbon source to the organometallic compound is 100:1-5.

7. The preparation method of the metal-doped silicon-carbon composite material according to claim 5, wherein in step (S1), the carbon source is one or any combination of phenolic resin, furfural resin, urea-formaldehyde resin, bisphenol F epoxy resin, bisphenol A epoxy resin, or bisphenol S epoxy resin; and/or the heteroatomic compound is one or any combination of urea, melamine, thiourea, thioacetamide, or phosphoric acid; and/or the organometallic compound is one or any combination of silver trifluoroacetate, silver stearate, silver benzoate, silver diethyldithiocarbamate, silver trifluoromethanesulfonate, copper 8-hydroxyquinoline, copper oleate, copper (II) carbonate dihydroxide, or copperphenylacetylide.

8. The preparation method of the metal-doped silicon-carbon composite material according to claim 5, wherein in step (S2), a volume ratio of chlorosilane to the inert gas in the mixed gas is 1-5:10; and/or the first reaction kettle is vacuumized to 10 kPa-100 kPa before the mixed gas is introduced into the first reaction kettle, and a vacuum degree of the first reaction kettle is maintained at 100 kPa-1000 kPa after the mixed gas is introduced into the first reaction kettle; and/or an introduction flow rate of the mixed gas is 10 ml/min-50 ml/min, and introduction duration is 60 min-300 min.

9. The preparation method of the metal-doped silicon-carbon composite material according to claim 5, wherein in step (S3), a mass ratio of the lithium salt to the activator to the organic solvent is 1-10:0.5-2:100; and/or the lithium salt is one or any combination of lithium borate, lithium tetraborate, lithium pyroborate, lithium metaborate, lithium tetrafluoroborate, or lithium stearate; the activator is one or any combination of CCl₃H, CCl₂H₂, or CClH₃; the organic solvent is one or any combination of dimethyl carbonate (DMC), diethyl carbonate (DEC), methyl ethyl carbonate (EMC), ethylene carbonate (EC), or propylene carbonate (PC); and the chamber containing the shell coating solution is vacuumized to 10 kPa-100 kPa and heated to 200°C-500°C to obtain the atomized gas.

10. Use of the metal-doped silicon-carbon composite material according to one of claims 1-4, wherein the metal-doped silicon-carbon composite material is used as an active substance raw material for preparing an electrode sheet of a battery, preferably, as an active substance raw material of a negative electrode sheet of a lithium-ion battery.
